# EUROPEAN PATENT SPECIFICATION

(11) **EP 4 395 461 B1**
(45) Date of publication and mention of the grant of the patent: **14.01.2026**
(21) Application number: 22861235.4
(22) Date of filing: 18.08.2022
(51) Int. Cl.: H05B 6/68, H05B 6/70, H05B 6/64

(54) **RF ENERGY RADIATION DEVICE**
RF-ENERGIE-STRAHLUNGSVORRICHTUNG
DISPOSITIF DE RAYONNEMENT D'ÉNERGIE RF

(30) Priority: 24.08.2021 JP 2021135995
(43) Date of publication of application: 03.07.2024
(73) Proprietor: Panasonic Intellectual Property Management Co., Ltd., Kadoma-shi, Osaka 571-0057 (JP)
(72) Inventor: TAKANO, Shinji, Osaka 571-0057 (JP); UNO, Takashi, Osaka 571-0057 (JP)
(74) Representative: SSM Sandmair
(86) International application number: PCT/JP2022/031189
(87) International publication number: WO 2023/026947

(56) References cited:
- WO-A1-2015/028839
- WO-A1-2018/056977
- WO-A1-2018/118034
- WO-A1-2020/050356
- CN-A- 106 604 436
- JP-A- 2000 058 252
- JP-A- 2013 510 414
- JP-A- 2017 221 656
- US-A1- 2017 359 863
- US-A1- 2018 153 000
- US-A1- 2020 305 244

## Description

### TECHNICAL FIELD

The present disclosure relates to improvements in reliability of RF energy radiation devices.

### BACKGROUND ART

Conventional RF (Radio Frequency) energy radiation devices detect reflected-wave power, thereby reducing their output power in accordance with the level of the reflected-wave power. Conventional RF energy radiation devices each supply output signals as burst waves such that the reflected-wave power does not exceed an allowable value. The supplying of output power as burst waves means that RF energy is radiated while alternatively providing on-time during which the output power is continuously supplied and off-time during which the output power is halted (see Patent Literature 1, for example).

Patent Literature 2 describes an RF energy radiation device that can accurately protect the device by means of hardware control and software control based on both detected values of reflected-wave power and detected temperatures of RF power elements.

The RF energy radiation device described in Patent Literature 2 is provided with a cavity for accommodating a heating target, an RF signal generator, an RF amplifier, a radiation element, a temperature sensor, and a controller. The RF power elements include, for example, a transistor included in an RF power amplifier for amplifying RF signals, and an RF power connector constituting a power supply unit. In the case where the RF energy radiation device is equipped with a circulator, the RF power elements further include a terminator and any other part for consuming the reflected waves.

Each of conventional RF energy radiation devices can continuously perform heating operation in the state where the load impedance between the device and a heating target is matched to some extent. Therefore, in order to protect its RF power elements from reflected waves, the device either reduces the output power or halts the heating operation upon satisfying predetermined conditions. As a result, some of the heating targets may not be sufficiently heated. The predetermined conditions described above involve the case where reflected-wave power of a predetermined magnitude is detected and the case where the temperature around the RF power elements rises higher than a predetermined value.

Moreover, in the case where RF power is supplied as a burst wave, the on-time is set such that the level of the reflected-wave power falls within an allowable range of the RF power elements. In operations such as plasma ignition, there are cases where load impedance becomes in the state of causing a total reflection of the RF energy at the start of operation.

For this reason, countermeasures against this have been taken such that an outside matching unit is used or such that the output level is once reduced at the start of operation followed by gradually raising it up to a predetermined value. Use of the matching unit requires a space allocated for the unit and costs thereof. This has been a barrier to development of the device.

In the case of the control by which the output level is gradually raised up to the predetermined value, an energy cannot be obtained enough to radiate RF energy onto the surface of a dielectric to ignite plasma. Raising the power level of the RF output to obtain a sufficient amount of RF energy for igniting plasma, will cause difficulties of protection of the device.

The heating operation can be performed by supplying the output power as a burst wave while changing the on-time of the output power without changing the peak of the power. When the RF power becomes insufficient, the output power is supplied continuously instead of supplied as a burst wave; however, even this case is difficult to protect the device.

The RF power elements include, for example, a transistor included in an RF power amplifier for amplifying RF signals, and an RF power connector constituting a power supply unit. In the case where the RF energy radiation device includes a circulator, a terminator for absorbing the reflected waves is also one of the RF power elements.

The matching unit includes not only a device containing distributed constants and lumped constants which both adjust load impedance, but also means for changing the angle and rotation angle of a radiation part that radiates microwaves.

### Citation List

### Patent Literature

PTL 1: Japanese Patent Unexamined Publication No. 2018-142452
PTL 2: Japanese Patent Unexamined Publication No. 2018-167408

### SUMMARY OF THE INVENTION

The present disclosure is aimed at providing an RF energy radiation device highly reliable for a heating target, a load.

An RF energy radiation device according to an aspect of the present disclosure includes an oscillator, a power amplifier, a radiation element, a detector, a controller, and a protection circuit.

The oscillator oscillates an RF signal having a variable pulse width and a variable pulse period. The power amplifier amplifies the RF signal to generate traveling-wave power. The radiation element radiates the traveling-wave power. The detector detects reflected-wave power that returns from the radiation element. The controller controls the oscillator and the power amplifier in accordance with the reflected-wave power, thereby setting an operation mode to either a first control mode or a second control mode.

In the first control mode, the controller performs a pulse width control to intermittently generate the traveling-wave power by setting the pulse width and the pulse period to a first pulse width and a first pulse period, respectively. The controller causes the oscillator to oscillate a pulsed RF signal having the first pulse width and the first pulse period. In the first control mode, the protection circuit does not shut off the power amplifier.

In the second control mode, the controller performs a pulse width control to intermittently generate the traveling-wave power by setting the pulse width and the pulse period to a second pulse width and a second pulse period, respectively. The second pulse width differs from the first pulse width. The second pulse period differs from the first pulse period. The controller causes the oscillator either to oscillate a pulsed RF signal having both the second pulse width and the second pulse period or to continuously oscillate the RF signal.

In the second control mode, the protection circuit shuts off the power amplifier when the reflected-wave power exceeds a predetermined threshold.

In the present disclosure, the pulse width control is performed in the first control mode at the start of operation such that the oscillator is not broken. The RF energy radiation device continues this operation until the load impedance of a heating target becomes stable. In the pulse width control, the pulse time with which the oscillator is not broken is varied in accordance with the temperature of the oscillator. According to the present disclosure, the reliability of the RF energy radiation device is increased.

### BRIEF DESCRIPTION OF DRAWINGS

FIG. 1 is a schematic diagram illustrating a configuration of an RF energy radiation device according to a first exemplary embodiment of the present disclosure.
FIG. 2 is a block diagram illustrating a protection circuit and its peripheral constituent elements of the RF energy radiation device according to the first exemplary embodiment.
FIG. 3 is a diagram illustrating an operation sequence of the RF energy radiation device according to the first exemplary embodiment.
FIG. 4 is a diagram illustrating an operation sequence of the RF energy radiation device according to the first exemplary embodiment.
FIG. 5 is a diagram illustrating an operation sequence of the RF energy radiation device according to the first exemplary embodiment.
FIG. 6 is a flowchart illustrating operations of the RF energy radiation device according to the first exemplary embodiment.
FIG. 7 shows a diagram illustrating an operation sequence of an RF energy radiation device according to a second exemplary embodiment of the present disclosure.
FIG. 8 is a flowchart illustrating operations of the RF energy radiation device according to the second exemplary embodiment.
FIG. 9 is a graph showing frequency characteristics of a reflectance obtained via a frequency sweep for the RF energy radiation device according to the second exemplary embodiment.

### DESCRIPTION OF EMBODIMENTS

An RF energy radiation device according to a first aspect of the present disclosure includes an oscillator, a power amplifier, a radiation element, a detector, a controller, and a protection circuit.

The oscillator oscillates an RF signal having a variable pulse width and a variable pulse period. The power amplifier amplifies the RF signal to generate traveling-wave power. The radiation element radiates the traveling-wave power. The detector detects reflected-wave power returning from the radiation element. The controller controls both the oscillator and the power amplifier in accordance with the reflected-wave power, thereby setting an operation mode to either a first control mode or a second control mode.

In the first control mode, the controller sets the pulse width and the pulse period to a first pulse width and a first pulse period, respectively, and performs a pulse width control to intermittently generate the traveling-wave power. The controller causes the oscillator to oscillate a pulsed RF signal having the first pulse width and the first pulse period. In the first control mode, the protection circuit does not shut off the power amplifier.

In the second control mode, the controller sets the pulse width and the pulse period to a second pulse width and a second pulse period, respectively, and performs the pulse width control to intermittently generate the traveling-wave power. The second pulse width differs from the first pulse width, and the second pulse period differs from the first pulse period. The controller causes the oscillator either to oscillate a pulsed RF signal having the second pulse width and the second pulse period or to continuously oscillate the RF signal.

In the second control mode, the protection circuit shuts off the power amplifier when the reflected-wave power exceeds a predetermined threshold.

The RF energy radiation device according to the aspect is capable of continuing its operation even when the traveling-wave power is almost totally reflected at the start of operation. This allows the improvement of reliability of the RF energy radiation device.

In the RF energy radiation device according to a second aspect of the present disclosure, in addition to the first aspect, in the first control mode, the controller causes the oscillator to oscillate the pulsed RF signal having a first pulse speed, and causes the power amplifier to generate a pulsed traveling-wave power having the first pulse speed.

In the second control mode, the controller causes the oscillator either to oscillate the pulsed RF signal having a second pulse speed slower than the first pulse speed or to continuously oscillate the RF signal. The controller causes the power amplifier to generate either a pulsed traveling-wave power having the second pulse speed or a continuous traveling-wave power.

The protection circuit includes a converter and a gate controller. The converter shuts off a pulsed reflected-wave power having the first pulse speed, and does not shut off both a pulsed reflected-wave power having the second pulse speed and a continuous reflected-wave power. The gate controller shuts off the traveling-wave power in accordance with an output signal from the converter.

According to the aspect, in the first control mode, the traveling-wave power is not shut off even when the reflected-wave power exceeds the predetermined threshold. That is, in the first control mode, the protection circuit does not function regardless of the reflected-wave power. In the second control mode, the protection circuit functions in accordance with the reflected-wave power.

In the RF energy radiation device according to a third aspect of the present disclosure, in addition to the first aspect, the controller shifts the operation mode from the first control mode to the second control mode after a lapse of a predetermined period since a load state has become stable in the first control mode. The controller shifts the operation mode from the second control mode to the first control mode in accordance with the load state after the operation mode has been shifted from the first control mode to the second control mode.

According to the aspect, when the load state becomes unstable after the load state has become stable, the operation mode may be set to the first control mode again.

In the RF energy radiation device according to a fourth aspect of the present disclosure, in addition to the first aspect, the controller determines stability of a load state based on the reflected-wave power, and causes the oscillator to vary both the pulse width of the RF signal and the pulse period of the RF signal. The controller changes a threshold voltage for determining the stability of the load state, in accordance with the pulse width and the pulse period.

The converter determines the stability of the load state based on the reflected-wave power. The allowable range of RF power elements against the reflected-wave power differs depending on the pulse width and pulse period of the traveling-wave power under the pulse width control and on the environmental temperature of the RF power elements. According to the aspect, the threshold voltage can be changed in accordance with these conditions.

In the case where the pulse time of the pulsed reflected-wave power is shorter than the response time of an A/D converter of a processor, the converter converts the pulsed reflected-wave power into a voltage. With this voltage, the stability of the load state can be determined.

The RF energy radiation device according to a fifth aspect of the present disclosure, in addition to the first aspect, further includes a memory to store, in advance, both unstable and stable time of a load state as a look-up table. The controller varies either the pulse width of the pulsed RF signals oscillated by the oscillator or the pulse period of the pulsed RF signals, based on the look-up table and a lapse of the operation time.

Specifically, the memory stores a look-up table of the processing in the first and the second control modes in the stable and unstable load states, with the processing being specified by various data, as setting conditions, that have been experimentally obtained in advance. This allows the radiation of RF energy to be ended without determination of the stability of the load state.

In the case where the pulse time of the reflected-wave power is shorter than the response time of the A/D converter of the processor, it is difficult to determine the stability of the load state; therefore, the method according to the aspect is effective as a control method in the case. What follows are examples of the various data stored in the memory as a look-up table.

For the first control mode, the following setting conditions depending on environmental temperature of RF power elements are stored in a look-up table: 1. output power, 2. frequency, 3. interval of frequency sweep, 4. operation time, 5. pulse time, 6. pulse period, and 7. pulse duty ratio.

For the second control mode, the following setting conditions depending on environmental temperature of the RF power elements are stored in the look-up table: 1. output power, 2. frequency, 3. operation time, 4. pulse time, 5. pulse period, 6. pulse duty ratio, and 7. threshold for determination of load stability. Note that the pulse time in the second control mode is longer than that in the first control mode. Moreover, in addition to the pulse width control for supplying a pulsed traveling-wave power, the second control mode also includes supplying a continuous traveling-wave power.

The RF energy radiation device according to a sixth aspect of the present disclosure, in addition to the first aspect, further includes a memory to store, in advance, a frequency of the RF signal in association with a lapse of operation time, as a look-up table, with the frequency being capable of providing stabilization of a load state.

The oscillator is capable of varying the frequency of the RF signal oscillating. The controller causes the oscillator to vary the frequency based on the look-up table and the lapse of the operation time. According to the aspect, it is possible to accelerate the stabilization of the load state.

In the RF energy radiation device according to a seventh aspect of the present disclosure, in addition to the first aspect, the oscillator is capable of varying a frequency of the RF signal oscillating. The controller determines stability of a load state based on an output signal from the detector. The controller causes the oscillator to vary the frequency of the RF signal with a lapse of operation time. According to the aspect, it is possible to accelerate the stabilization of the load state by performing a frequency sweep.

The RF energy radiation device according to an eighth aspect of the present disclosure, in addition to the first aspect, further includes a terminator to terminate the reflected-wave power, and a temperature sensor to detect both temperature of the power amplifier and temperature of the terminator. The oscillator is capable of varying a frequency of the RF signal oscillating.

The controller causes the oscillator to vary either the pulse width or the pulse period based on the temperatures of both the power amplifier and the terminator in the first control mode. This provides a safe range in which the power amplifier and the terminator are not broken by the reflected-wave power. According to the aspect, the reliability of the RF energy radiation device can be improved.

In the RF energy radiation device according to a ninth aspect of the present disclosure, in addition to the first aspect, in the pulse width control, the controller causes the power amplifier both to set the traveling-wave power during on-time to a first power level and to set the traveling-wave power during off-time to a second power level. The second power level is a power level not equal to zero and lower than the first power level.

According to the aspect, during the off-time in the pulse width control, an idling current is allowed to some extent to continue flowing to the output circuit of the power supply to power amplifier 2a. This allows the stabilization of output voltage of the power supply to the power amplifier.

Hereinafter, exemplary embodiments of the present disclosure will be described with reference to the accompanying drawings.

### (First Exemplary Embodiment)

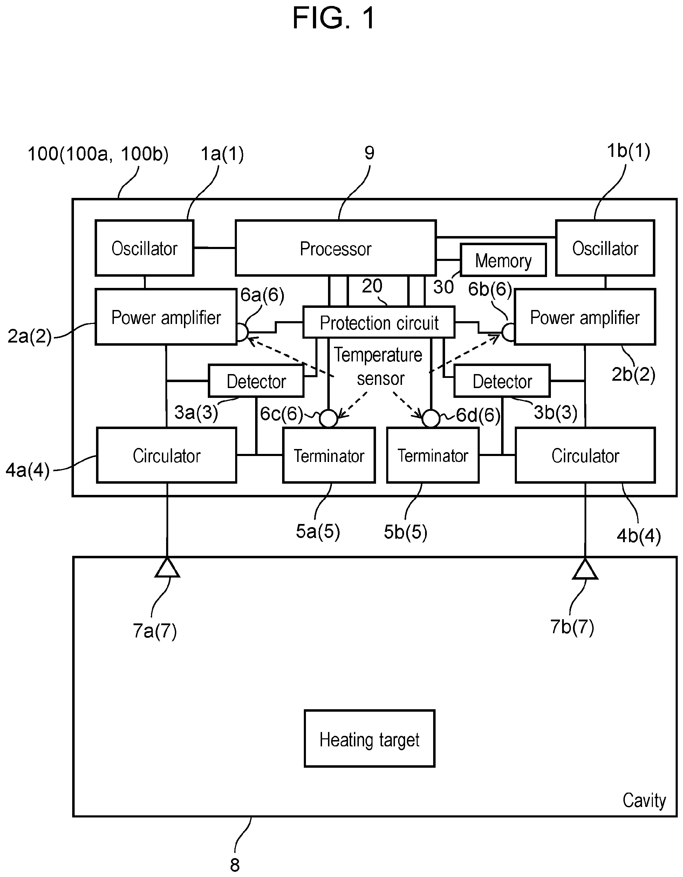

FIG. 1 is a schematic diagram illustrating a configuration of RF energy radiation device 100 according to a first exemplary embodiment of the present disclosure.

As shown in FIG. 1, RF energy radiation device 100 includes oscillator 1, power amplifier 2, detector 3, circulator 4, terminator 5, temperature sensor 6, radiation element 7, processor 9, protection circuit 20, and memory 30.

Oscillator 1 includes two oscillators (1a, 1b). Power amplifier 2 includes two power amplifiers (2a, 2b). Detector 3 includes two detectors (3a, 3b). Circulator 4 includes two circulators (4a, 4b).

Terminator 5 includes two terminators (5a, 5b). Temperature sensor 6 includes four temperature sensors (6a, 6b, 6c, 6d). Radiation element 7 includes two radiation elements (7a, 7b).

Each of oscillator 1a and oscillator 1b oscillates an RF signal, and outputs it. Power amplifiers 2a and 2b each amplify the RF signal having been oscillated by oscillators 1a and 1b, and output the resulting signal as traveling-wave power. Both detectors 3a and 3b detect traveling-wave power and reflected-wave power.

The traveling-wave power is RF energies that travel from power amplifiers 2a and 2b via circulators 4a and 4b toward radiation elements 7a and 7b, respectively. The reflected-wave power is RF energies, among those originally composing the traveling-wave power, that return from radiation elements 7a and 7b back to circulators 4a and 4b, respectively.

Circulators 4a and 4b are disposed in paths of the traveling-wave power and paths of the reflected-wave power. Circulators 4a and 4b respectively protect power amplifiers 2a and 2b from the reflected-wave power that varies depending on load variations of a heating target. Terminators 5a and 5b have a specific impedance that serves as a load to the reflected-wave power traveling from circulators 4a and 4b, respectively.

Radiation element 7a radiates, into cavity 8, the RF energy transmitted from power amplifier 2a via circulator 4a. Radiation element 7b radiates, into cavity 8, the RF energy transmitted from power amplifier 2b via circulator 4b. The RF energies heat the heating target placed inside cavity 8.

Temperature sensor 6a and temperature sensor 6b are disposed in the vicinity of power amplifiers 2a and 2b to detect the temperatures of power amplifiers 2a and 2b, respectively. Temperature sensor 6c and temperature sensor 6d are disposed in the vicinity of terminators 5a and 5b to detect the temperatures of terminators 5a and 5b, respectively.

Memory 30 is a semiconductor memory, for example, that stores software and data which both are used by processor 9. The data stored in memory 30 include a look-up table that is prepared in advance for setting an RF energy suitable for the temperatures detected by temperature sensors 6a to 6d.

Processor 9 is a general-purpose microprocessor that functions as a controller for controlling RF energy radiation device 100. Processor 9 controls oscillators 1a and 1b and power amplifiers 2a and 2b in accordance with the temperature detected by each of temperature sensors 6a to 6d.

Specifically, processor 9 causes oscillators 1a and 1b to oscillate RF signals that have any frequencies within a predetermined frequency band. Moreover, processor 9 performs a pulse width control by causing oscillators 1a and 1b to oscillate RF signals that have variable pulse widths and variable pulse periods. The pulse width control, variable pulse width, and variable pulse period will be described later.

In the embodiment, processor 9 can refer to the temperature, e.g., 50 times per second, that is detected by each of temperature sensors 6a to 6d. In accordance with these temperatures, processor 9 can output instructions, e.g., 50 times per second, to oscillators 1a and 1b and power amplifiers 2a and 2b. That is, the period (referred to as a control period, hereinafter) of the software control performed by processor 9 is 20 ms.

Protection circuit 20 functions to protect the circuits inside the device, based on the traveling-wave power and reflected-wave power detected by detectors 3a and 3b and the temperatures detected by temperature sensors 6a to 6d.

As described above, the reflected-wave power that varies depending on load variations, passes through circulator 4 to reach terminator 5 and is consumed by terminator 5. This mitigates the influence of the reflected-wave power on power amplifier 2 and reduces the variations in characteristics of power amplifier 2 due to the load variations. In this way, circulator 4 protects power amplifier 2.

However, terminator 5 generates heat accompanying the consumption of the reflected-wave power, which imposes restrictions on the operation of RF energy radiation device 100. Taking a lifetime of terminator 5 into consideration, terminator 5 is used such that the temperature rise due to the heat generation falls within a safe range in the service environment. Therefore, whenever the reflected-wave power is at a high level, the continuous service of RF energy radiation device 100 is restricted.

As shown in FIG. 1, RF energy radiation device 100 includes two systems of RF energy radiation devices that have the same configuration. One of the two systems is disposed on the radiation element 7a side, and the other is on the radiation element 7b side. Processor 9, protection circuit 20, and memory 30 are common to the two systems of RF energy radiation devices.

Hereinafter, descriptions are made only regarding RF energy radiation device 100a that is the system on the radiation element 7a side, while descriptions are omitted regarding RF energy radiation device 100b, i.e., the system on the radiation element 7b side.

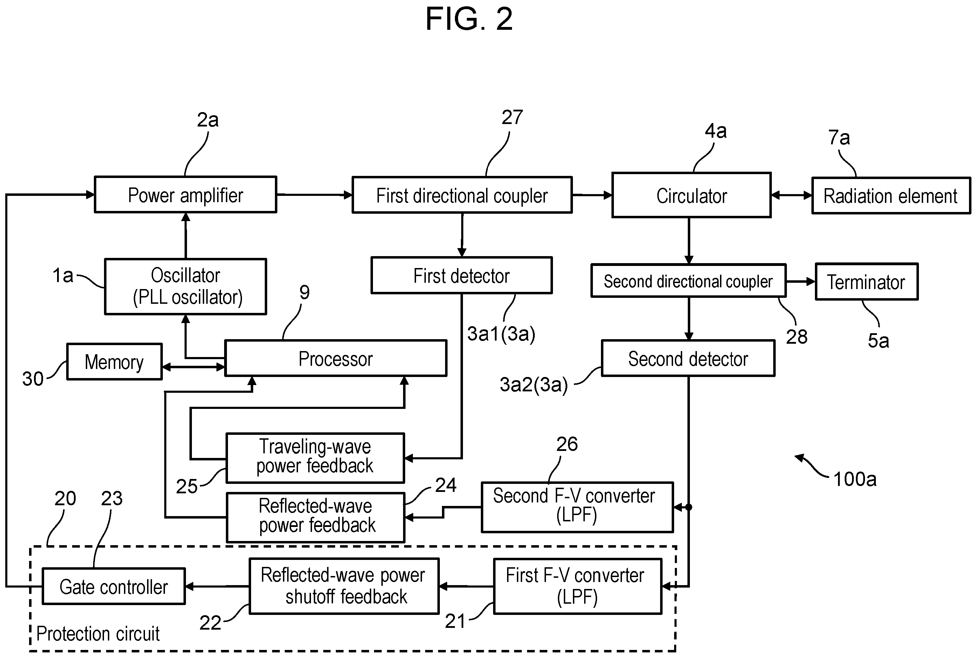

FIG. 2 is a block diagram illustrating details of protection circuit 20 of RF energy radiation device 100a according to the embodiment, and peripheral constituent elements of protection circuit 20.

As shown in FIG. 2, RF energy radiation device 100a includes oscillator 1a, power amplifier 2a, detector 3a, circulator 4a, terminator 5a, radiation element 7a, reflected-wave power feedback 24, traveling-wave power feedback 25, second F-V converter 26, first directional coupler 27, and second directional coupler 28. Detector 3a includes first detector 3a1 and second detector 3a2.

First directional coupler 27 is disposed between power amplifier 2a and circulator 4a. First directional coupler 27 transmits, to first detector 3a1, part of the traveling-wave power that travels from power amplifier 2a to circulator 4a. First detector 3a1 detects part of the traveling-wave power, and transmits the detected signal to traveling-wave power feedback 25. Traveling-wave power feedback 25 receives the signal transmitted from first detector 3a1, and detects the level of the traveling-wave power based on the received signal.

Second directional coupler 28 is disposed between circulator 4a and terminator 5a. Second directional coupler 28 transmits, to second detector 3a2, part of the reflected-wave power that travels from circulator 4a to terminator 5a. Second detector 3a2 detects part of the reflected-wave power, and transmits the detected signal to second F-V converter 26.

Second F-V converter 26 is a lowpass filter that receives the signal transmitted from second detector 3a2, smooths the received signal, and outputs the smoothed signal. That is, second F-V converter 26 converts the part of the reflected-wave power, which is detected by second detector 3a2, into a voltage level in accordance with the level of the reflected-wave power. Reflected-wave power feedback 24 detects the level of the reflected-wave power based on the voltage level transmitted from second F-V converter 26.

RF energy radiation device 100a further includes processor 9, protection circuit 20, and memory 30, all of which are constituent elements common to RF energy radiation device 100b. Protection circuit 20 includes first F-V converter 21, reflected-wave power shutoff feedback 22, and gate controller 23.

Like second F-V converter 26, first F-V converter 21 is also a lowpass filter that receives the signal transmitted from second detector 3a2, smooths the received signal, and outputs the smoothed signal. That is, first F-V converter 21 converts the part of the reflected-wave power, which is detected by second detector 3a2, into a voltage level in accordance with the level of the reflected-wave power.

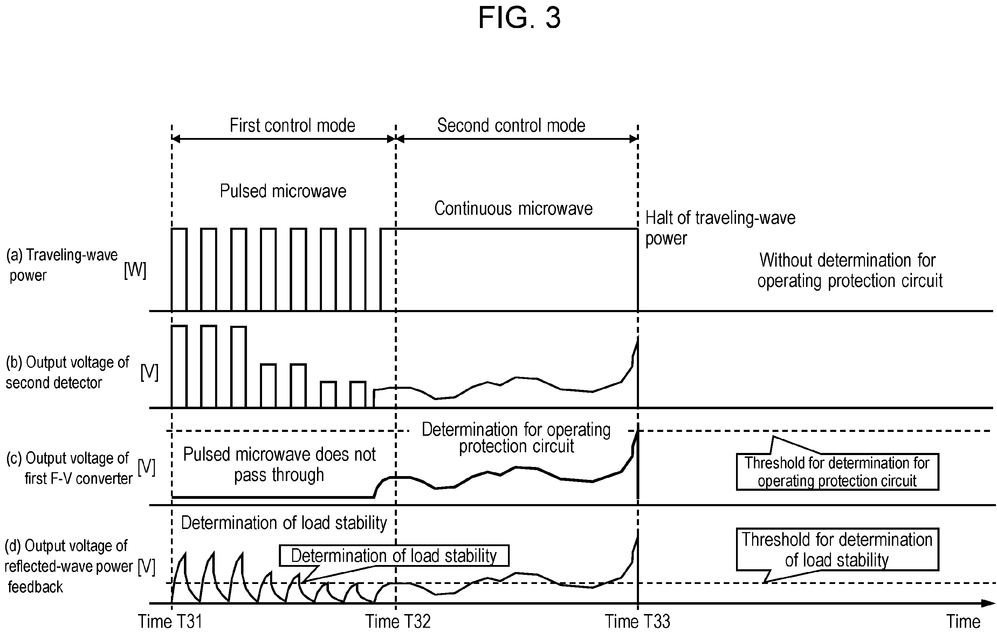

Circuit constants of first F-V converter 21 are set such that, in a first control mode, a pulsed reflected-wave power having a first pulse speed (to be described later) is not allowed to pass through it. The circuit constants of first F-V converter 21 are set such that, in a second control mode, both a pulsed reflected-wave power having a second pulse speed (to be described later) and a continuous reflected-wave power are allowed to pass through it. Therefore, in the first control mode, the power level of the output from first F-V converter 21 is always zero. On the other hand, in the second control mode, first F-V converter 21 outputs a voltage level in accordance with the reflected-wave power [see waveform (c) in FIG. 3].

That is, in the first control mode, reflected-wave power shutoff feedback 22 does not shut off power amplifier 2a so as not to shut off the traveling-wave power. In the second control mode, reflected-wave power shutoff feedback 22 shuts off power amplifier 2a in accordance with the voltage level output from first F-V converter 21 so as to shut off the traveling-wave power.

Operations and actions of RF energy radiation device 100 configured as described above will be described with reference to FIGS. 3 to 5.

FIG. 3 shows one example of the operation sequence in which the operation mode is shifted from the first control mode to the second control mode. As shown in FIG. 3, at time T31, processor 9 sets the operation mode to the first control mode to start operating RF energy radiation device 100a.

Processor 9 causes oscillator 1a to oscillate an RF signal having a desired frequency while alternately turning on and off the power supply to oscillator 1a. With this operation, oscillator 1a oscillates the RF signal, while alternately providing the on-time during which the RF signal continuously oscillates and the off-time during which the RF signal halts the oscillation. Processor 9 causes power amplifier 2a to amplify the RF signal such that the RF energy rises to reach a desired output value.

As a result, in the first control mode, a pulsed microwave is supplied to cavity 8 as traveling-wave power.

Note that the terms "supplying a pulsed microwave (traveling-wave power)" referred to herein means that power amplifier 2a outputs the pulsed microwave (traveling-wave power) while alternately providing the on-time and the off-time. The on-time is the time during which power amplifier 2a continuously outputs the traveling-wave power. The off-time is the time during which power amplifier 2a halts the output of the traveling-wave power.

In the embodiment, the pulse width control is defined as supplying a pulsed microwave (traveling-wave power) while adjusting both the amplification degree of the RF signal and the durations of the on-time and off-time. In the pulse width control, a pulse width (pulse time) is the duration of the on-time, and a pulse period is the sum of the durations of the on-time and off-time.

In other words, the pulse width control is to generate a pulsed microwave (traveling-wave power), that is, to intermittently generate a microwave (traveling-wave power).

On the other hand, continuously supplying of a microwave (traveling-wave power) without the pulse width control is to supply a continuous microwave (traveling-wave power).

Processor 9 calculates the pulse width and pulse period based on both the temperature of terminator 5a measured by temperature sensor 6c (see FIG. 1) and the safe service range of terminator 5a with respect to temperature. The safe service range of terminator 5a with respect to temperature is stored in advance in memory 30.

In the case where RF energy radiation device 100a does not includes circulator 4a, the safe service range of power amplifier 2a is taken into account as a condition for setting the pulse width and the pulse period. That is, in the first control mode, the pulse width and the pulse period may be controlled based on the temperatures of power amplifier 2a and terminator 5a such that a safe range is provided in which power amplifier 2a and terminator 5a are not broken by the reflected-wave power.

As shown in waveform (a) of FIG. 3, in the first control mode, the RF energy is supplied as a pulsed microwave (traveling-wave power) that has one or both of a predetermined pulse width and a predetermined pulse period.

Waveform (b) of FIG. 3 is an output signal of second detector 3a2 that indicates the voltage in accordance with the reflected-wave power detected by second detector 3a2. Waveform (c) of FIG. 3 is an output signal of first F-V converter 21 that indicates the voltage in accordance with the reflected-wave power having passed through first F-V converter 21. Waveform (d) of FIG. 3 is an output signal of reflected-wave power feedback 24. This signal is a voltage that indicates the level of the reflected-wave power detected by reflected-wave power feedback 24, and is fed to an A/D (analog/digital) converter of processor 9.

Usually, second F-V converter 26 is disposed at the preceding stage of reflected-wave power feedback 24. Second F-V converter 26 functions as a lowpass filter (LPF) for removing noises such as ripples of supplied power. Waveform (d) of FIG. 3 is a differential waveform after having passed through the LPF.

In the pulse width control, the pulse width and the pulse period are adjustable. For example, the pulse period can be set to any value within the range of 10 µs to 2 ms in accordance with the environmental temperature and load state of terminator 5a. The threshold voltage for determining the stability of the load state is changeable by means of one or both of the pulse width and the pulse period. Since load response characteristics of the power supply for oscillator 1a need to be taken into account, there are cases where an optimum period is chosen in view of the capacitor capacitance of the conducting wire for the power supply.

After starting operation in the first control mode, as indicated by waveform (b) of FIG. 3, when the pulsed traveling-wave power is reflected by almost total reflection, it generates a pulsed reflected-wave power.

First F-V converter 21 does not transmit the pulsed reflected-wave power in the first control mode, which is attributed to the converter's circuit constants. In the second control mode, first F-V converter 21 transmits a pulsed reflected-wave power having a slower pulse speed than that in the first control mode, and transmits a continuous reflected-wave power.

In the embodiment, the pulse speed is the inverse of the pulse period of a microwave in the pulse width control. The pulse speed in the first control mode is referred to as a first pulse speed. The pulse speed in the second control mode is referred to as a second pulse speed. The second pulse speed is slower than the first pulse speed.

In the second control mode, processor 9 causes oscillator 1a to oscillate either a pulsed RF signal that has the second pulse speed slower than the first pulse speed in the first control mode or a continuous RF signal. As a result, in the second control mode, radiation element 7a radiates a continuous traveling-wave power or a pulsed traveling-wave power that has the second pulse speed slower than the first pulse speed in the first control mode.

Moreover, the pulse width and pulse period in the first control mode are referred to as a first pulse width and a first pulse period, respectively. The pulse width and pulse period in the second control mode are referred to as a second pulse width and a second pulse period, respectively. The first pulse width and the first pulse period are different from the second pulse width and the second pulse period, respectively.

First F-V converter 21 is a filter circuit using passive elements (resister, capacitor, and inductor). Alternatively, first F-V converter 21 may be an active filter that can adaptively change its time constant through use of passive elements, an operational amplifier, and a digital potentiometer.

In the first control mode, first F-V converter 21 does not transmit, to reflected-wave power shutoff feedback 22, the voltage equivalent to the protection threshold against the reflected-wave power. As a result, even in the load state in which a total reflection takes place, processor 9 does not shut off oscillator 1a. That is, in the first control mode, even when the level of the reflected-wave power detected by second detector 3a2 exceeds a predetermined threshold, oscillator 1a does not shut off the RF energy.

With this configuration, even in the case of the load state being unstable, RF energy radiation device 100a can continue the operation without a halt.

In the first control mode, when the output signal of reflected-wave power feedback 24 indicated by waveform (d) of FIG. 3 becomes equal to or lower than a first threshold, processor 9 determines that the load state has become stable (time T32). The first threshold is a predetermined threshold for determining the load state by software. The terms "determining the load state by software" means that the stability of the load state is determined by processor 9 based on the output signal of reflected-wave power feedback 24 indicated by waveform (d) of FIG. 3.

When the load state becomes stable, processor 9 shifts the operation mode from the first control mode in which a pulsed microwave is radiated to the second control mode in which a continuous traveling-wave power is radiated. In the second control mode, either a pulsed traveling-wave power or a continuous traveling-wave power is output. The pulsed microwave in the second control mode is different, in pulse width and pulse period, from the pulsed microwave in the first control mode, and has a pulse speed slower than that in the first control mode.

For a continuous microwave, the reflected-wave power detected by second detector 3a2 is transmitted via first F-V converter 21 to reflected-wave power shutoff feedback 22.

In the second control mode, there are cases where the load state becomes unstable and the reflected-wave power increases. Therefore, reflected-wave power shutoff feedback 22 determines whether the level of the reflected-wave power exceeds a predetermined threshold set by hardware. When the reflected-wave power exceeds the predetermined threshold [see waveform (c) of FIG. 3], gate controller 23 shuts off power amplifier 2a [see waveform (a) of FIG. 3].

In this way, protection circuit 20 starts operating to protect the RF power elements from the reflected-wave power. After that, no determination is made for causing protection circuit 20 to start operating.

In the first control mode, in order to maintain the stability of the load state, the operation mode may be switched from the first control mode to the second control mode after the first control mode is continued only for a predetermined period since the load state has become stable.

In the second control mode, first F-V converter 21 outputs the reflected-wave power as it is which has been input thereinto. When reflected-wave power shutoff feedback 22 detects that the level of the reflected-wave power exceeds the predetermined threshold, gate controller 23 shuts off power amplifier 2a (time T33). This causes the radiation of RF energy to halt, thereby protecting terminator 5a from the excessive reflected-wave power.

One example of the hardware configuration of reflected-wave power shutoff feedback 22 is a comparator. The safe service range of terminator 5a varies depending on the environmental temperature. For this reason, processor 9 adjusts the threshold voltage of the comparator via a D/A (digital/analog) converter.

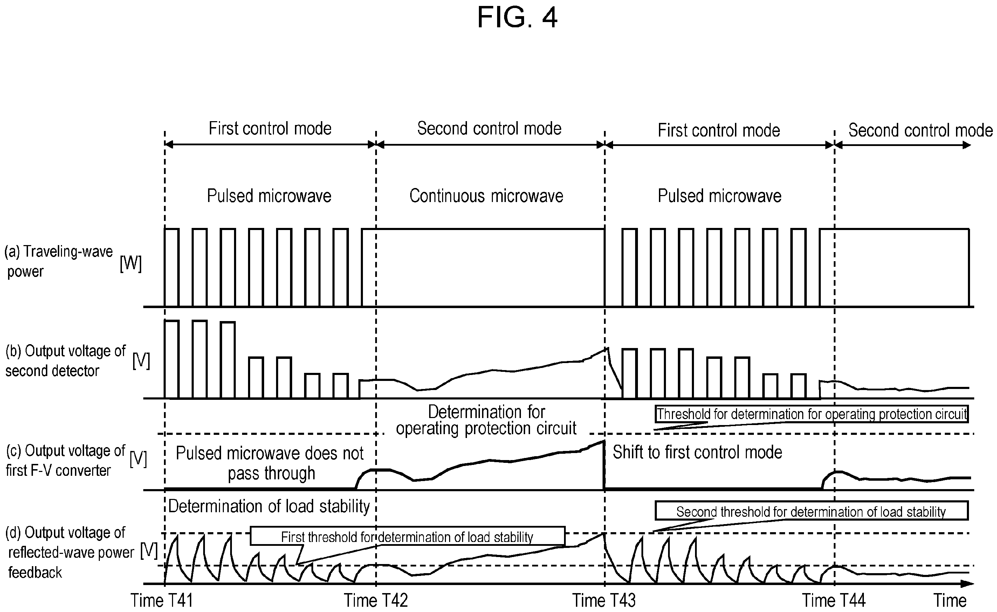

In the case where the reflected-wave power rises after the operation mode has been shifted to the second control mode, processor 9 may return the operation mode from the second control mode to the first control mode again. FIG. 4 shows the operation sequence in this case. Waveform (a) to waveform (d) of FIG. 4 are signals corresponding to waveform (a) to waveform (d) of FIG. 3, respectively. The vertical and horizontal axes of waveform (a) to waveform (d) of FIG. 4 are equivalent to those of waveform (a) to waveform (d) of FIG. 3, respectively.

In FIG. 4, the forms of signals shown in waveform (a) to waveform (d) of FIG. 4 from time T41 to just before T43 are the same as the corresponding ones in waveform (a) to waveform (d) of FIG. 3. Accordingly, descriptions will be made regarding the operation sequence at and after time T43.

As shown in waveform (d) of FIG. 4, at time T43, reflected-wave power feedback 24 determines that the output signal of first F-V converter 21 exceeds a second threshold. The second threshold is a predetermined threshold for determining the load state by software, and is higher than the first threshold. In this case, the operation mode is shifted from the second control mode to the first control mode.

Processor 9 continues the operation in the first control mode, until the load becomes stable, by means of imposing a pulse width control that allows terminator 5a to operate within its safe service range. As described above, the terms "the load state becomes stable" means that the output signal of reflected-wave power feedback 24 indicated by waveform (d) of FIG. 4 becomes equal to or lower than the first threshold.

At time T44, when the output signal of reflected-wave power feedback 24 indicated by waveform (d) of FIG. 4 becomes equal to or lower than the first threshold, processor 9 determines that the load state has become stable. When the load state has become stable, processor 9 shifts the operation mode from the first control mode to the second control mode again.

In the first control mode, shortening of the pulse period allows the operation to continue within the safe service range of the RF power elements with respect to the reflected-wave power. Depending on the load response characteristics of the power supply, the current rapidly increases during the rising of the traveling-wave power in the pulse width control. This may result in a transitory restriction on the output voltage of the power supply to power amplifier 2a. In this case, the traveling-wave power is shut off before the traveling-wave power reaches a desired value.

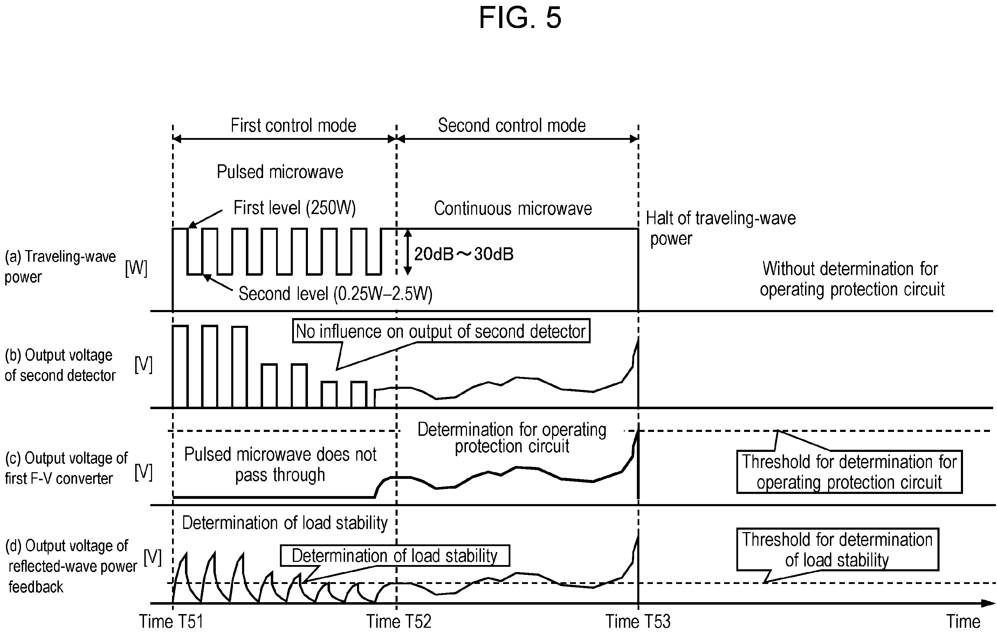

FIG. 5 shows one example of the operation sequence of the pulse width control aiming at solving this problem. Waveform (a) to waveform (d) of FIG. 5 are signals corresponding to waveform (a) to waveform (d) of FIG. 3, respectively. The vertical and horizontal axes of waveform (a) to waveform (d) of FIG. 5 are equivalent to those of waveform (a) to waveform (d) of FIG. 3, respectively.

As shown in FIG. 5, at time T51 to time T52, the level of the traveling-wave power during the on-time in the pulse width control is set to the first power level the same as that in the case of FIG. 3. On the other hand, the traveling-wave power during the off-time is set to a second power level that is not zero and is lower than the first power level. The second power level is a power level lower enough to have no influence on a heating target.

In this way, during the off-time in the pulse width control, a certain amount of current is allowed to continue flowing to the output circuit of the power supply to power amplifier 2a. This results in the stabilized output voltage of the power supply to power amplifier 2a.

In FIG. 5, after the operation mode has been shifted to the second control mode, the sequences are the same as those in FIG. 3. When reflected-wave power shutoff feedback 22 detects that the level of the reflected-wave power exceeds the predetermined threshold, gate controller 23 shuts off power amplifier 2a (time T53).

In the case shown in FIG. 5, an ON/OFF ratio, i.e., a ratio of the first power level of the traveling-wave power to the second power level of the traveling-wave power is adjustable in the range of 20 dB to 30 dB. Therefore, in the case of the traveling-wave power of 250 W, the traveling-wave power of 0.25 W to 2.5 W is output during the off-time. The ON/OFF ratio is appropriately set in accordance with the level of the traveling-wave power.

In the case shown in FIG. 5, detector 3a includes a logarithmic amplifier having an input range of 20 dB, and the range in which an input power can be converted into a voltage is about 20 dB.

Even when the traveling-wave power of 0.25 W to 2.5 W is totally reflected and is then input into second detector 3a2 as reflected-wave power, the output voltage of second detector 3a2 has no influence on the first control mode.

Temperature sensor 6c (see FIG. 1) monitors the temperature of terminator 5a. In the case of the load state being unstable, when the temperature out of the safe service range of terminator 5a is detected, processor 9 causes RF energy radiation device 100a to halt its operation.

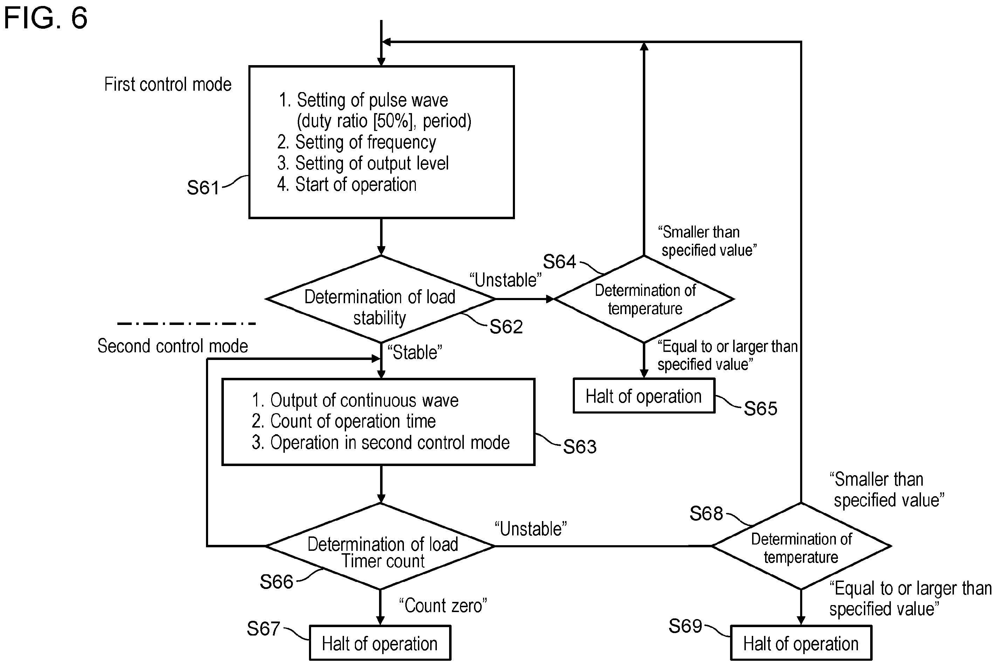

FIG. 6 is one example of a flowchart indicating the operations of RF energy radiation device 100a according to the embodiment.

At the start of operation of RF energy radiation device 100a, in Step S61, processor 9 sets the operation mode to the first control mode. Processor 9 causes oscillator 1a to oscillate an RF signal having a desired frequency. At the same time, processor 9 causes power amplifier 2a to amplify the RF signal to generate RF energy of a desired output level.

In the first control mode, processor 9 outputs the RF energy by the pulse width control. In the pulse width control, the duty is set to 50%. The duty is a ratio of the on-time to the sum of the on-time during which the RF energy is continuously output and the off-time during which the output of the RF energy is halted.

In the first control mode, when determining the load state being stable, by software, from the output signal of reflected-wave power feedback 24 (determination "stable" in Step S62), processor 9 shifts the operation mode to the second control mode. In the second control mode, processor 9 controls oscillator 1a and power amplifier 2a to radiate a continuous traveling-wave power. Processor 9 starts a timer count of the operation time and performs the operation in the second control mode (Step S63).

In the first control mode, when determining the load state not being stable, by software (determination "unstable" in Step S62), processor 9 takes the temperature of terminator 5a into consideration (Step S64). When temperature out of the safe service range of terminator 5a is detected (determination "not smaller than specified value" in Step S64), processor 9 causes RF energy radiation device 100a to halt its operation (Step S65).

As described above, in Step S63, when the operation in the second control mode is performed, reflected-wave power shutoff feedback 22 monitors the output voltage of first F-V converter 21 (Step S66). When the level of the output signal of first F-V converter 21 exceeds a predetermined threshold (determination "unstable" in Step S66), processor 9 interprets the state as a sudden load variation and monitors the temperature of terminator 5a (Step S68). When temperature out of the safe service range of terminator 5a is detected (determination "not smaller than specified value" in Step S68), processor 9 causes RF energy radiation device 100a to halt its operation (Step S69).

Moreover, when the timer count of the operation time in the second control mode becomes zero (determination "count zero" in Step S66), processor 9 causes RF energy radiation device 100a to halt its operation (Step S67).

In Step S64, when temperature within the safe service range of terminator 5a is detected (determination "smaller than specified value" in Step S64), processor 9 returns the process to Step S61. Similarly, in Step S68, when temperature within the safe service range of terminator 5a is detected (determination "smaller than specified value" in Step S68), processor 9 returns the process to Step S61.

Memory 30 may store the unstable time and stable time of the load state in advance as a look-up table in association with the lapse of the operation time. Based on the look-up table and the lapse of the operation time, processor 9 may cause oscillator 1a to change either the pulse width or pulse period of the pulsed RF signals.

The unstable time of the load state is the duration of a period during which the load state is unstable, and is experimentally determined in advance. The stable time of the load state is the duration of a period during which the load state is stable, and is experimentally determined in advance. That is, processor 9 can switch the operation mode by means of a feedforward control based on the look-up table, instead of a feedback control based on the reflected-wave power.

RF energy radiation device 100a executes both the first control mode and the second control mode through use of hardware and software.

In the first control mode, the pulse width control is performed. In the pulse width control, the pulse time is set such that, when the traveling-wave power is totally reflected, the reflected-wave power falls within the allowable range of the RF power elements. In the embodiment, the RF power elements include oscillator 1a, power amplifier 2a, and terminator 5a. Further, the pulse time is set such that the temperature rise of the RF power elements during the operation of RF energy radiation device 100a falls within the safe service range of the RF power elements.

RF energy radiation device 100a includes constituent elements for causing protection circuit 20, which is to protect the RF power elements from the reflected-wave power in the first control mode, to halt. These constituent elements include first F-V converter 21 and second F-V converter 26.

In the second control mode, there are radiated either the pulsed traveling-wave power having a pulse speed slower than that in the first control mode or the continuous traveling-wave power. This allows RF energy radiation device 100a to be protected from both the level of the reflected-wave power and the temperature rise of the temperature sensors.

As a result, in the first control mode, the operation can be continued until the load impedance becomes stable with a heating target that has load characteristics causing a total reflection.

After the load impedance has become stable, the operation mode is shifted to the second control mode. In the second control mode, the radiation can be continued for a period during which the RF energy is required. In accordance with the environmental temperature of the RF power elements, the safe service range of the RF power elements may also be adaptably varied. Note that the terms "the load impedance has become stable" means that the load impedance is in a range close to the output impedance of RF energy radiation device 100a.

### (Second Exemplary Embodiment)

Hereinafter, RF energy radiation device 100a according to a second exemplary embodiment of the present disclosure will be described. RF energy radiation device 100a according to the present embodiment has the same configuration as that according to the first embodiment. The present embodiment is different from the first embodiment in that, upon starting operation of RF energy radiation device 100a, processor 9 starts by performing a frequency sweep.

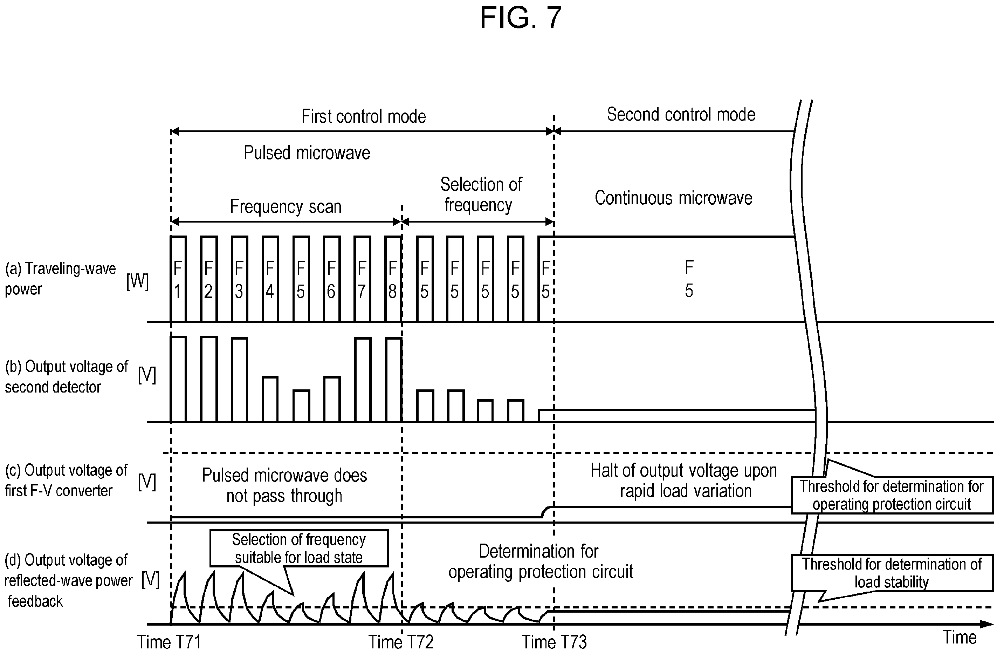

FIG. 7 shows an operation sequence of RF energy radiation device 100a according to the second exemplary embodiment of the present disclosure. As indicated by waveform (a) of FIG. 7, when RF energy radiation device 100a starts operation, in the first control mode, processor 9 performs a frequency sweep (time T71).

In the frequency sweep, processor 9 causes oscillator 1a to oscillate an RF signal, with the signal's frequency being varied sequentially at predetermined frequency intervals over a predetermined frequency band (e.g., 2.4 GHz to 2.5 GHz).

Specifically, as indicated by waveform (a) of FIG. 7, oscillator 1a first oscillates a microwave having frequency F1 only during a predetermined on-time and then, after a lapse of the on-time, halts the operation. After a predetermined off-time, oscillator 1a oscillates a microwave having frequency F2 only during a predetermined on-time and then, after a lapse of the on-time, halts the operation. In this way, oscillator 1a oscillates RF signals sequentially with a predetermined pulse width and predetermined pulse period, with each of the RF signals has one of frequency F1 to frequency F8 in order (time T71 to time T72).

Note that, assuming that "n" is a natural number not smaller than 1 and not larger than 7, frequency Fn+1 is larger than frequency Fn and the frequency interval between frequency Fn+1 and frequency Fn is constant.

Oscillator 1a may be configured with a VCO (voltage-controlled oscillator) and a PLL (phase locked loop) or, alternatively, configured with a DDS (direct digital synthesizer) featuring a fast frequency shift time. Which one is selected depends on the pulse period of the pulse width control to be used. Moreover, the period of varying the frequency in the frequency sweep depends on the control period of processor 9.

Second detector 3a2 detects, within the control period, the level of the reflected-wave power that has any one of frequency F1 to frequency F8. Information regarding this detection is input to the A/D (analog/digital) converter of processor 9 via reflected-wave power feedback 24.

Processor 9 selects a have-to-be-used frequency from among the frequencies of the reflected-wave power measured through the frequency sweep, with the have-to-be-used frequency being the frequency or near it which gives the lowest reflected-wave power measured through the frequency sweep (time T72). Processor 9 performs the pulse width control in the first control mode by using a microwave that has the frequency selected as the have-to-be-used frequency. In waveform (a) of FIG. 7, frequency F5 is selected as the have-to-be-used frequency.

When the load state has become stable so that the reflected-wave power is equal to or lower than a predetermined threshold for determination by software, processor 9 shifts the operation mode from the first control mode to the second control mode (time T73). As described above, the terms "the load state has become stable" means that the output signal of reflected-wave power feedback 24 indicated by waveform (d) of FIG. 7 has become equal to or lower than a first threshold.

Variably controlling the frequency to accelerate the stabilization of the load state allows the operation mode to be more quickly shifted from the first control mode to the second control mode. This improves the reliability of the stabilization of the load state. As a result, when radiating RF energy for plasma ignition or the like, it possible to search for a frequency, from the state of total reflection, that allows quicker and easier ignition. This results in an increase in the probability of the ignition.

In the embodiment, as in the case of the first embodiment (see FIG. 4), when the load state becomes unstable after having shifted to the second control mode, processor 9 shifts the operation mode to the first control mode and performs the frequency sweep again. This makes it possible to search again for a frequency that allows stabilization of the load state.

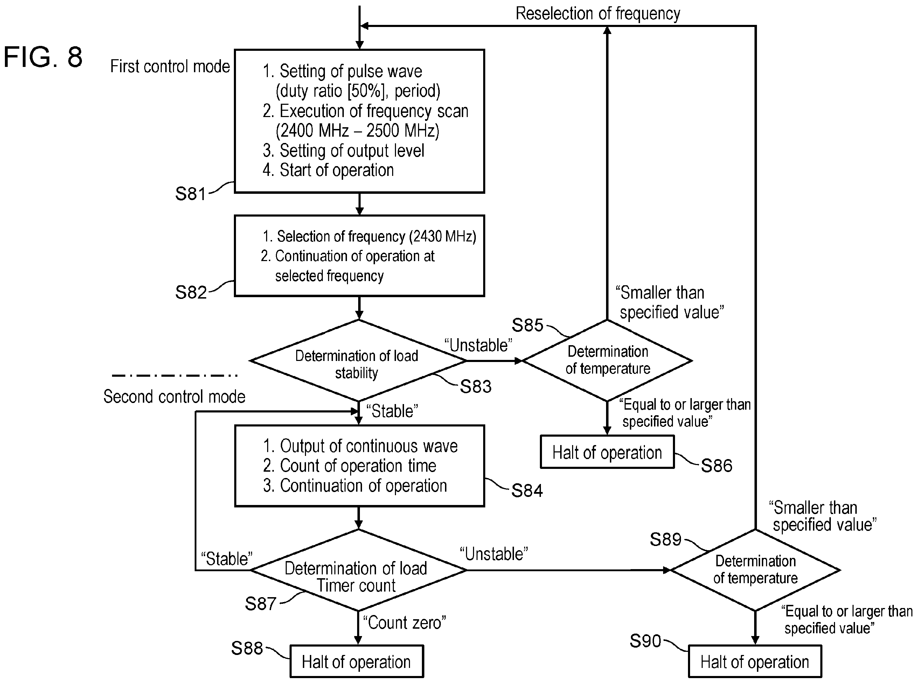

FIG. 8 is a flowchart illustrating operations of RF energy radiation device 100a according to the embodiment.

When starting operation of RF energy radiation device 100a, in Step S81, processor 9 sets the operation mode to the first control mode and causes oscillator 1a to oscillate RF signals for performing a frequency sweep. At the same time, processor 9 causes power amplifier 2a to amplify the RF signals to generate the RF energies of a desired output level.

In the embodiment, in the first control mode, the pulse width in the pulse width control is set to half of the pulse period. That is, the duty in the pulse width control is set to 50%.

In Step S82, processor 9 selects a have-to-be-used frequency by means of the frequency sweep. Processor 9 continues the pulse width control by using a microwave having the frequency selected as the have-to-be-used frequency.

In the first control mode, when recognizing the load state being stable, by software, from the output signal of reflected-wave power feedback 24 (determination "stable" in Step S83), processor 9 shifts the operation mode to the second control mode. In the second control mode, processor 9 controls oscillator 1a and power amplifier 2a to radiate a continuous traveling-wave power. Processor 9 starts a timer count of the operation time and performs the operation in the second control mode (Step S84).

In the first control mode, when recognizing the load state not being stable, by software (determination "unstable" in Step S83), processor 9 takes the temperature of terminator 5a into consideration (Step S85). When temperature out of the safe service range of terminator 5a is detected (determination "not smaller than specified value" in Step S85), processor 9 causes RF energy radiation device 100a to halt its operation (Step S86).

As described above, in Step S84, during the operation in the second control mode is performed, reflected-wave power shutoff feedback 22 monitors the output voltage of first F-V converter 21 (Step S87). When the level of the output signal of first F-V converter 21 does not exceed a predetermined threshold (determination "stable" in Step S87), processor 9 returns the process to Step S84.

When the level of the output signal of first F-V converter 21 exceeds a predetermined threshold (determination "unstable" in Step S87), processor 9 interprets the state as a sudden load variation and monitors the temperature of terminator 5a (Step S89). When temperature out of the safe service range of terminator 5a is detected (determination "not smaller than specified value" in Step S89), processor 9 causes RF energy radiation device 100a to halt its operation (Step S90).

Moreover, when the timer count of the operation time in the second control mode becomes zero (determination "count zero" in Step S87), processor 9 causes RF energy radiation device 100a to halt its operation (Step S88).

In Step S85, when temperature within the safe service range of terminator 5 is detected (determination "smaller than specified value" in Step S85), processor 9 returns the process to Step S81. Similarly, in Step S89, when temperature within the safe service range of terminator 5 is detected (determination "smaller than specified value" in Step S89), processor 9 returns the process to Step S81.

Note that processor 9 may perform a frequency sweep again to select a have-to-be-used frequency, followed by performing the same operation as the above again.

In the embodiment, as shown in FIG. 7, processor 9 performs the frequency sweep and thereby selects frequency F5 as the to-be-used frequency. However, the present disclosure is not limited to this. Processor 9 may select a to-be-used frequency based on a reflectance obtained during the frequency sweep.

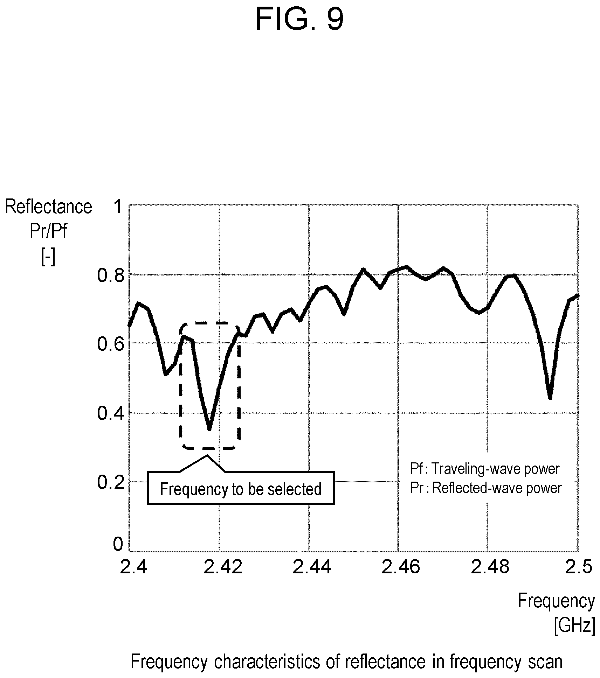

FIG. 9 shows the frequency characteristics of a reflectance obtained via a frequency sweep. In FIG. 9, the horizontal axis represents the frequency of traveling-wave power and the vertical axis represents the reflectance. The reflectance is the ratio of the reflected-wave power (Pr) to the traveling-wave power (Pf) and serves as an indicator of the stability of the load. As shown in FIG. 9, processor 9 selects a frequency, as a to-be-used frequency, in the vicinity of 2.42 GHz that provides the smallest reflectance, for example.

Memory 30 may store, in advance, operation conditions (e.g., pulse widths, frequencies, and operation time) for the pulse width control in the first control mode, as a menu in accordance with types of heating targets.

Memory 30 may also store, in advance, frequencies capable of providing stabilized load states, in association with a lapse of the operation time, as a look-up table. Processor 9 may also cause oscillator 1a to vary the frequency based on both the lapse of the operation time and the look-up table.

Processor 9 may also obtain a signal from detector 3a, thereby determine a frequency capable of providing a stabilized load state, and cause oscillator 1a to vary the frequency in accordance with the lapse of the operation time.

### INDUSTRIAL APPLICABILITY

As described above, the RF energy radiation devices according to the present disclosure are applicable to, for example, heating devices such as a heating device for business use which require high accuracy in controlling the output of RF energies.

### REFERENCE MARKS IN THE DRAWINGS

1, 1a, 1b oscillator
2, 2a, 2b power amplifier
3, 3a, 3b detector
3a1 first detector
3a2 second detector
4, 4a, 4b circulator
5, 5a, 5b terminator
6, 6a, 6b, 6c, 6d temperature sensor
7, 7a, 7b radiation element
8 cavity
9 processor (controller)
20 protection circuit
21 first F-V converter
22 reflected-wave power shutoff feedback
23 gate controller
24 reflected-wave power feedback
25 traveling-wave power feedback
26 second F-V converter
27 first directional coupler
28 second directional coupler
30 memory
100, 100a, 100b RF energy radiation device

## Claims

1. An RF energy radiation device (100, 100a, 100b), comprising:
an oscillator (1, 1a, 1b) configured to oscillate an RF signal having
a variable pulse width and
a variable pulse period;
a power amplifier (2, 2a, 2b) configured to amplify the RF signal to generate traveling-wave power;
a radiation element (7, 7a, 7b) configured to radiate the traveling-wave power;
a detector (3, 3a, 3b) configured to detect reflected-wave power returning from the radiation element; and
a controller (9) configured to control both the oscillator and the power amplifier in accordance with the reflected-wave power,
**characterized in that**,
the controller is configured to set an operation mode to either a first control mode or a second control mode,
wherein the first control mode includes
performing a pulse width control to generate the traveling-wave power by performing one or both of setting the pulse width to a predetermined pulse width and setting the pulse period to a predetermined pulse period,
wherein the second control mode includes
performing the pulse width control to generate the traveling-wave power by performing one or both of setting the pulse width to a pulse width different from the pulse width in the first control mode and setting the pulse period to a pulse period different from the pulse period in the first control mode, and
wherein the traveling-wave power is not shut off in the first control mode, and the traveling-wave power is shut off when the reflected-wave power exceeds a predetermined threshold in the second control mode.

2. The RF energy radiation device according to claim 1, further comprising:
a protection circuit (20),
wherein, in the first control mode, the controller is configured to perform a pulse width control to intermittently generate the traveling-wave power by setting the pulse width to a first pulse width and setting the pulse period to a first pulse period, and the controller is configured to cause the oscillator to oscillate a pulsed RF signal having the first pulse width and the first pulse period,
wherein, in the first control mode, the protection circuit is configured not to shut off the traveling-wave power,
wherein, in the second control mode, the controller is configured to perform the pulse width control to intermittently generate the traveling-wave power by setting the pulse width to a second pulse width and setting the pulse period to a second pulse period, the second pulse width differing from the first pulse width, the second pulse period differing from the first pulse period,
wherein the controller is configured to cause the oscillator either to oscillate a pulsed RF signal having the second pulse width and the second pulse period or to continuously oscillate the RF signal, and
wherein, in the second control mode, the protection circuit is configured to shut off the traveling-wave power when the reflected-wave power exceeds a predetermined threshold.

3. The RF energy radiation device according to claim 2,
wherein, in the first control mode, the controller is configured to cause the oscillator to oscillate the pulsed RF signal having a first pulse speed, and the controller is configured to cause the power amplifier to generate a pulsed travelling-wave power having the first pulse speed,
wherein, in the second control mode, the controller is configured to cause the oscillator either to oscillate the pulsed RF signal having a second pulse speed slower than the first pulse speed or to continuously oscillate the RF signal, and the controller is configured to cause the power amplifier to generate either a pulsed travelling-wave power having the second pulse speed or a continuous travelling-wave power,
wherein the protection circuit includes
a converter (21, 26) and
a gate controller (23),
wherein the converter is configured to shut off a pulsed reflected-wave power having a first pulse speed, and configured not to shut off both a pulsed reflected-wave power having the second pulse speed and a continuous reflected-wave power, and
wherein the gate controller is configured to shut off the traveling-wave power in accordance with an output from the converter.

4. The RF energy radiation device according to claim 1,
wherein the controller is configured to shift the operation mode to the second control mode after a lapse of a predetermined period since a load state has become stable in the first control mode, and
wherein the controller is configured to shift the operation mode from the second control mode to the first control mode in accordance with the load state after the operation mode has been shifted from the first control mode to the second control mode.

5. The RF energy radiation device according to claim 1,
wherein the controller is configured to determine stability of a load state based on the reflected-wave power, and to cause the oscillator to vary both the pulse width of the RF signal and the pulse period of the RF signal, and
wherein the controller is configured to change a threshold voltage for determining the stability of the load state, in accordance with the pulse width and the pulse period.

6. The RF energy radiation device according to claim 2, further comprising:
a memory (30) configured to store, in advance, both unstable time of a load state and stable time of the load state in association with a lapse of operation time, as a look-up table,
wherein the controller is configured to vary either the pulse width of the pulsed RF signals oscillated by the oscillator or the pulse period of the pulsed RF signals, based on the look-up table and the lapse of the operation time.

7. The RF energy radiation device according to claim 1, further comprising:
a memory configured to store, in advance, a frequency of the RF signal in association with a lapse of operation time, as a look-up table, the frequency being capable of providing stabilization of a load state,
wherein the oscillator is capable of varying the frequency of the RF signal oscillating, and
wherein the controller is configured to cause the oscillator to vary the frequency based on the look-up table and the lapse of the operation time.

8. The RF energy radiation device according to claim 1,
wherein the oscillator is capable of varying a frequency of the RF signal oscillating,
wherein the controller is configured to determine stability of a load state based on an output signal from the detector, and
wherein the controller is configured to cause the oscillator to vary the frequency of the RF signal with a lapse of operation time.

9. The RF energy radiation device according to claim 1, further comprising:
a terminator (5, 5a, 5b) configured to terminate the reflected-wave power; and
a temperature sensor (6, 6a, 6b, 6c, 6d) configured to detect both temperature of the power amplifier and temperature of the terminator,
wherein the oscillator is capable of varying a frequency of the RF signal oscillating, and
wherein, in the first control mode, in order to provide a safe range in which the power amplifier and the terminator are not broken by the reflected-wave power, the controller is configured to cause the oscillator to vary either the pulse width or the pulse period, based on both the temperature of the power amplifier and the temperature of the terminator.

10. The RF energy radiation device according to claim 1, wherein, in the pulse width control, the controller is configured to cause the power amplifier both to set the traveling-wave power during on-time to a first power level and to set the traveling-wave power during off-time to a second power level not equal to zero and lower than the first power level.

## Patentansprüche

1. RF-Energiestrahlungsvorrichtung (100, 100a, 100b), die umfasst:
einen Oszillator (1, 1a, 1b), der so konfiguriert ist, dass er ein RF-Signal oszilliert, mit
einer variablen Pulsbreite und
einer variablen Pulsperiode;
einen Leistungsverstärker (2, 2a, 2b), der so konfiguriert ist, dass er das RF-Signal verstärkt, um Wanderwellenleistung zu erzeugen;
ein Strahlungselement (7, 7a, 7b), das so konfiguriert ist, dass es die Wanderwellenleistung abstrahlt;
einen Detektor (3, 3a, 3b), der so konfiguriert ist, dass er die vom Strahlungselement reflektierte Wellenleistung erfasst; und
eine Steuerung (9), die so konfiguriert ist, dass sie sowohl den Oszillator als auch den Leistungsverstärker entsprechend der reflektierten Wellenleistung steuert,
**dadurch gekennzeichnet, dass**
die Steuerung so konfiguriert ist, dass sie einen Betriebsmodus entweder auf einen ersten oder einen zweiten Steuermodus einstellt,
wobei der erste Steuermodus Folgendes umfasst:
durch eine Pulsbreitensteuerung wird die Leistung der Wanderwelle erzeugt, indem entweder die Pulsbreite auf eine vorgegebene Pulsbreite oder die Pulsperiode auf eine vorgegebene Pulsperiode eingestellt wird,
wobei der zweite Steuermodus Folgendes umfasst:
die Pulsbreitensteuerung zur Erzeugung der Wanderwellenleistung erfolgt durch Einstellen der Pulsbreite auf eine von der Pulsbreite im ersten Steuermodus abweichende Pulsbreite und/oder Einstellen der Pulsperiode auf eine von der Pulsperiode im ersten Steuermodus abweichende Pulsperiode,
wobei im ersten Steuermodus die Wanderwellenleistung nicht abgeschaltet wird und im zweiten Steuermodus die Wanderwellenleistung abgeschaltet wird, wenn die reflektierte Wellenleistung einen vorbestimmten Schwellenwert überschreitet.

2. RF-Energiestrahlungsvorrichtung nach Anspruch 1, die ferner umfasst:
eine Schutzschaltung (20),
wobei die Steuerung im ersten Steuermodus so konfiguriert ist, dass sie eine Pulsbreitensteuerung durchführt, um die Wanderwellenleistung intermittierend zu erzeugen, indem sie die Pulsbreite auf eine erste Pulsbreite und die Pulsperiode auf eine erste Pulsperiode einstellt, und die Steuerung so konfiguriert ist, dass der Oszillator ein oszilliertes RF-Signal mit der ersten Pulsbreite und der ersten Pulsperiode oszilliert,
wobei im ersten Steuermodus die Schutzschaltung so konfiguriert ist, dass sie die Wanderwellenleistung nicht abschaltet,
wobei die Steuerung im zweiten Steuermodus so konfiguriert ist, dass sie die Pulsbreitensteuerung durchführt, um die Wanderwellenleistung intermittierend zu erzeugen, indem sie die Pulsbreite auf eine zweite Pulsbreite und die Pulsperiode auf eine zweite Pulsperiode einstellt, wobei sich die zweite Pulsbreite von der ersten Pulsbreite und die zweite Pulsperiode von der ersten Pulsperiode unterscheidet,
wobei die Steuerung so konfiguriert ist, dass der Oszillator entweder ein oszilliertes RF-Signal mit der zweiten Pulsbreite und der zweiten Pulsperiode erzeugt oder das RF-Signal kontinuierlich erzeugt, und
wobei im zweiten Steuermodus die Schutzschaltung so konfiguriert ist, dass sie die Leistung der Wanderwelle abschaltet, wenn die Leistung der reflektierten Welle einen vorbestimmten Schwellenwert überschreitet.

3. RF-Energiestrahlungsvorrichtung nach Anspruch 2,
wobei im ersten Steuermodus die Steuerung so konfiguriert ist, dass sie den Oszillator dazu bringt, das oszillierte RF-Signal mit einer ersten Pulsfrequenz zu oszillieren, und so, dass der Leistungsverstärker eine oszillierte Wanderwellenleistung mit der ersten Pulsfrequenz erzeugt,
wobei im zweiten Steuermodus die Steuerung so konfiguriert ist, dass der Oszillator entweder das oszillierte RF-Signal mit einer zweiten Pulsfrequenz, die langsamer als die erste Pulsfrequenz ist, oder das RF-Signal kontinuierlich oszilliert, und der Steuerung so konfiguriert ist, dass der Leistungsverstärker entweder eine oszillierte Wanderwellenleistung mit der zweiten Pulsfrequenz oder eine kontinuierliche Wanderwellenleistung erzeugt,
wobei die Schutzschaltung Folgendes umfasst:
einen Wandler (21, 26) und
eine Gate-Steuerung (23),
wobei der Wandler so konfiguriert ist, dass er eine oszillierte reflektierte Wellenleistung mit einer ersten Pulsfrequenz abschaltet und gleichzeitig eine oszillierte reflektierte Wellenleistung mit der zweiten Pulsfrequenz sowie eine kontinuierliche reflektierte Wellenleistung nicht abschaltet, und
wobei die Gate-Steuerung so konfiguriert ist, dass sie die Wanderwellenleistung entsprechend einem Ausgangssignal des Wandlers abschaltet.

4. RF-Energiestrahlungsvorrichtung nach Anspruch 1,
wobei die Steuerung so konfiguriert ist, dass sie nach Ablauf einer vorbestimmten Zeitspanne, nachdem sich ein stabiler Lastzustand im ersten Steuermodus eingestellt hat, in den zweiten Steuermodus schaltet, und
wobei die Steuerung so konfiguriert ist, dass sie den Betriebsmodus nach dem Wechsel vom ersten zum zweiten Steuermodus entsprechend dem Lastzustand vom zweiten Steuermodus in den ersten Steuermodus schaltet.

5. RF-Energiestrahlungsvorrichtung nach Anspruch 1,
wobei die Steuerung so konfiguriert ist, dass sie die Stabilität eines Lastzustands anhand der reflektierten Wellenleistung bestimmt und den Oszillator veranlasst, sowohl die Pulsbreite als auch die Pulsperiode des RF-Signals zu variieren, und
wobei die Steuerung so konfiguriert ist, dass sie eine Schwellenspannung zur Bestimmung der Stabilität des Lastzustands in Abhängigkeit von der Pulsbreite und der Pulsperiode ändert.

6. RF-Energiestrahlungsvorrichtung nach Anspruch 2, die ferner umfasst:
einen Speicher (30), der so konfiguriert ist, dass er sowohl die instabile Zeit eines Lastzustands als auch die stabile Zeit des Lastzustands in Verbindung mit einer verstrichenen Betriebszeit im Voraus als Nachschlagetabelle speichert,
wobei die Steuerung so konfiguriert ist, dass sie entweder die Pulsbreite des vom Oszillator erzeugten oszillierten RF-Signals oder die Pulsperiode des oszillierten RF-Signals auf Basis der Nachschlagetabelle und der verstrichenen Betriebszeit variiert.

7. RF-Energiestrahlungsvorrichtung nach Anspruch 1, die ferner umfasst:
einen Speicher, der so konfiguriert ist, dass er im Voraus eine Frequenz des RF-Signals in Verbindung mit einer verstrichenen Betriebszeit als Nachschlagetabelle speichert, wobei die Frequenz zur Stabilisierung eines Lastzustands geeignet ist,
wobei der Oszillator die Frequenz des oszillierenden RF-Signals variieren kann, und
wobei die Steuerung konfiguriert ist, um die Frequenz des Oszillators anhand der Nachschlagetabelle und der verstrichenen Betriebszeit zu variieren.

8. RF-Energiestrahlungsvorrichtung nach Anspruch 1,
wobei der Oszillator in der Lage ist, die Frequenz des oszillierenden RF-Signals zu variieren,
wobei die Steuerung so konfiguriert ist, dass sie die Stabilität eines Lastzustands auf der Grundlage eines Ausgangssignals des Detektors bestimmt, und
wobei die Steuerung so konfiguriert ist, dass der Oszillator die Frequenz des RF-Signals mit Ablauf einer Betriebszeit verändert.

9. RF-Energiestrahlungsvorrichtung nach Anspruch 1, die ferner umfasst:
ein Abschlusswiderstand (5, 5a, 5b), der so konfiguriert ist, dass er die Leistung der reflektierten Welle abschließt; und
ein Temperatursensor (6, 6a, 6b, 6c, 6d), der sowohl die Temperatur des Leistungsverstärkers als auch die Temperatur des Abschlusswiderstands erfasst,
wobei der Oszillator die Frequenz des oszillierenden RF-Signals variieren kann, und
wobei im ersten Steuermodus die Steuerung so konfiguriert ist, dass sie, um einen sicheren Bereich zu gewährleisten, in dem der Leistungsverstärker und der Abschlusswiderstand nicht durch die reflektierte Wellenleistung beschädigt werden, den Oszillator veranlasst, entweder die Pulsbreite oder die Pulsperiode auf der Grundlage der Temperatur des Leistungsverstärkers und der Temperatur des Abschlusswiderstands zu variieren.

10. RF-Energiestrahlungsvorrichtung nach Anspruch 1, wobei die Steuerung der Pulsbreite so konfiguriert ist, dass der Leistungsverstärker sowohl die Wanderwellenleistung während der Einschaltzeit auf einen ersten Leistungspegel einstellt als auch die Wanderwellenleistung während der Ausschaltzeit auf einen zweiten Leistungspegel einstellt, der ungleich Null und niedriger als der erste Leistungspegel ist.

## Revendications

1. Dispositif de rayonnement d'énergie RF (100, 100a, 100b), comprenant :
un oscillateur (1, 1a, 1b) configuré pour faire osciller un signal RF présentant
une largeur d'impulsion variable et
une période d'impulsion variable ;
un amplificateur de puissance (2, 2a, 2b) configuré pour amplifier le signal RF afin de générer une puissance d'onde progressive ;
un élément de rayonnement (7, 7a, 7b) configuré pour rayonner la puissance d'onde progressive ;
un détecteur (3, 3a, 3b) configuré pour détecter une puissance d'onde réfléchie renvoyée par l'élément de rayonnement ; et
un dispositif de commande (9) configuré pour commander à la fois l'oscillateur et l'amplificateur de puissance conformément à la puissance d'onde réfléchie,
**caractérisé en ce que**,
le dispositif de commande est configuré pour établir un mode de fonctionnement soit à un premier mode de commande, soit à un deuxième mode de commande,
dans lequel le premier mode de commande inclut
la réalisation d'une commande de largeur d'impulsion pour générer la puissance d'onde progressive en réalisant l'établissement de la largeur d'impulsion à une largeur d'impulsion prédéterminée et/ou l'établissement de la période d'impulsion à une période d'impulsion prédéterminée,
dans lequel le deuxième mode de commande inclut
la réalisation de la commande de largeur d'impulsion pour générer la puissance d'onde progressive en réalisant l'établissement de la largeur d'impulsion à une largeur d'impulsion différente de la largeur d'impulsion dans le premier mode de commande et/ou l'établissement de la période d'impulsion à une période d'impulsion différente de la période d'impulsion dans le premier mode de commande, et
dans lequel la puissance d'onde progressive n'est pas coupée dans le premier mode de commande, et la puissance d'onde progressive est coupée lorsque la puissance d'onde réfléchie dépasse un seuil prédéterminé dans le deuxième mode de commande.

2. Dispositif de rayonnement d'énergie RF selon la revendication 1, comprenant en outre :
un circuit de protection (20),
dans lequel, dans le premier mode de commande, le dispositif de commande est configuré pour réaliser une commande de largeur d'impulsion afin de générer de manière intermittente la puissance d'onde progressive en établissant la largeur d'impulsion à une première largeur d'impulsion et en établissant la période d'impulsion à une première période d'impulsion, et le dispositif de commande est configuré pour amener l'oscillateur à faire osciller un signal RF pulsé présentant la première largeur d'impulsion et la première période d'impulsion,
dans lequel, dans le premier mode de commande, le circuit de protection est configuré pour ne pas couper la puissance d'onde progressive,
dans lequel, dans le deuxième mode de commande, le dispositif de commande est configuré pour réaliser la commande de largeur d'impulsion afin de générer de manière intermittente la puissance d'onde progressive en établissant la largeur d'impulsion à une deuxième largeur d'impulsion et en établissant la période d'impulsion à une deuxième période d'impulsion, la deuxième largeur d'impulsion différant de la première largeur d'impulsion, la deuxième période d'impulsion différant de la première période d'impulsion,
dans lequel le dispositif de commande est configuré pour amener l'oscillateur soit à faire osciller un signal RF pulsé présentant la deuxième largeur d'impulsion et la deuxième période d'impulsion, soit à faire osciller en continu le signal RF, et
dans lequel, dans le deuxième mode de commande, le circuit de protection est configuré pour couper la puissance d'onde progressive lorsque la puissance d'onde réfléchie dépasse un seuil prédéterminé.

3. Dispositif de rayonnement d'énergie RF selon la revendication 2,
dans lequel, dans le premier mode de commande, le dispositif de commande est configuré pour amener l'oscillateur à faire osciller le signal RF pulsé présentant une première vitesse d'impulsion, et le dispositif de commande est configuré pour amener l'amplificateur de puissance à générer une puissance d'onde progressive pulsée présentant la première vitesse d'impulsion,
dans lequel, dans le deuxième mode de commande, le dispositif de commande est configuré pour amener l'oscillateur soit à faire osciller le signal RF pulsé présentant une deuxième vitesse d'impulsion plus lente que la première vitesse d'impulsion, soit à faire osciller en continu le signal RF, et le dispositif de commande est configuré pour amener l'amplificateur de puissance à générer soit une puissance d'onde progressive pulsée présentant la deuxième vitesse d'impulsion, soit une puissance d'onde progressive continue,
dans lequel le circuit de protection inclut
un convertisseur (21, 26) et
un dispositif de commande de porte (23),
dans lequel le convertisseur est configuré pour couper une puissance d'onde réfléchie pulsée présentant une première vitesse d'impulsion, et configuré pour ne pas couper à la fois une puissance d'onde réfléchie pulsée présentant la deuxième vitesse d'impulsion et une puissance d'onde réfléchie continue, et
dans lequel le dispositif de commande de porte est configuré pour couper la puissance d'onde progressive conformément à une sortie à partir du convertisseur.

4. Dispositif de rayonnement d'énergie RF selon la revendication 1,
dans lequel le dispositif de commande est configuré pour faire basculer le mode de fonctionnement au deuxième mode de commande après l'écoulement d'une période prédéterminée depuis un état de charge devenu stable dans le premier mode de commande, et
dans lequel le dispositif de commande est configuré pour faire basculer le mode de fonctionnement du deuxième mode de commande au premier mode de commande conformément à l'état de charge après le basculement du mode de fonctionnement du premier mode de commande au deuxième mode de commande.

5. Dispositif de rayonnement d'énergie RF selon la revendication 1,
dans lequel le dispositif de commande est configuré pour déterminer une stabilité d'un état de charge sur la base de la puissance d'onde réfléchie, et pour amener l'oscillateur à faire varier à la fois la largeur d'impulsion du signal RF et la période d'impulsion du signal RF, et
dans lequel le dispositif de commande est configuré pour modifier une tension seuil pour déterminer la stabilité de l'état de charge, conformément à la largeur d'impulsion et à la période d'impulsion.

6. Dispositif de rayonnement d'énergie RF selon la revendication 2, comprenant en outre :
une mémoire (30) configurée pour stocker, à l'avance, à la fois une durée instable d'un état de charge et une durée stable de l'état de charge en association avec un écoulement de temps de fonctionnement, sous la forme d'une table de consultation,
dans lequel le dispositif de commande est configuré pour faire varier soit la largeur d'impulsion des signaux RF pulsés oscillés par l'oscillateur, soit la période d'impulsion des signaux RF pulsés, sur la base de la table de consultation et de l'écoulement du temps de fonctionnement.

7. Dispositif de rayonnement d'énergie RF selon la revendication 1, comprenant en outre :
une mémoire configurée pour stocker, à l'avance, une fréquence du signal RF en association avec un écoulement de temps de fonctionnement, sous la forme d'une table de consultation, la fréquence étant capable d'assurer une stabilisation d'un état de charge,
dans lequel l'oscillateur est capable de faire varier la fréquence du signal RF oscillant, et
dans lequel le dispositif de commande est configuré pour amener l'oscillateur à faire varier la fréquence sur la base de la table de consultation et de l'écoulement du temps de fonctionnement.

8. Dispositif de rayonnement d'énergie RF selon la revendication 1,
dans lequel l'oscillateur est capable de faire varier une fréquence du signal RF oscillant,
dans lequel le dispositif de commande est configuré pour déterminer une stabilité d'un état de charge sur la base d'un signal de sortie à partir du détecteur, et
dans lequel le dispositif de commande est configuré pour amener l'oscillateur à faire varier la fréquence du signal RF avec un écoulement de temps de fonctionnement.

9. Dispositif de rayonnement d'énergie RF selon la revendication 1, comprenant en outre :
un terminateur (5, 5a, 5b) configuré pour terminer la puissance d'onde réfléchie ; et
un capteur de température (6, 6a, 6b, 6c, 6d) configuré pour détecter à la fois la température de l'amplificateur de puissance et la température du terminateur,
dans lequel l'oscillateur est capable de faire varier une fréquence du signal RF oscillant, et
dans lequel, dans le premier mode de commande, afin de fournir une plage de sécurité dans laquelle l'amplificateur de puissance et le terminateur ne sont pas endommagés par la puissance d'onde réfléchie, le dispositif de commande est configuré pour amener l'oscillateur à faire varier soit la largeur d'impulsion, soit la période d'impulsion, sur la base à la fois de la température de l'amplificateur de puissance et de la température du terminateur.

10. Dispositif de rayonnement d'énergie RF selon la revendication 1, dans lequel, dans la commande de largeur d'impulsion, le dispositif de commande est configuré pour amener l'amplificateur de puissance à la fois à établir la puissance d'onde progressive pendant une durée d'activation à un premier niveau de puissance et à établir la puissance d'onde progressive pendant une durée de désactivation à un deuxième niveau de puissance non égal à zéro et inférieur au premier niveau de puissance.
